# EUROPEAN PATENT APPLICATION

(11) **EP 4 704 495 A1**
(43) Date of publication of application: **04.03.2026**
(21) Application number: 25196746.9
(22) Date of filing: 19.08.2025
(51) Int. Cl.: H05K 1/02, H05K 1/14, H05K 1/181

(54) **SYSTEMS AND METHODS OF DELIVERING POWER TO AN APPLICATION SPECIFIC INTEGRATED CIRCUIT**

(30) Priority: 30.08.2024 US 202418821452
(71) Applicant: Arista Networks, Inc., Santa Clara, CA 95054 (US)
(72) Inventor: MEGGITT, Warren Justin, Santa Clara, CA 95054 (US); BYSTROM, Daniel John, Santa Clara, CA 95054 (US); HEMP, Adam Michael, Santa Clara, CA 95054 (US)
(74) Representative: Hoffmann Eitle

(57) **Abstract**

Systems and methods for supplying high power from a power supply to an ASIC are disclosed. Embodiments may mount an ASIC on a host board on which the ASIC and utilize a separate daughter board to mount the power supply. Electrical connectors suitable for use with higher power level, such as pin-and-collar, type connectors are used to connect the daughter board to the host board such that high current may be carried from the power supply on the daughter board to the ASIC on the host board through these electrical connectors.

## Description

### BACKGROUND

Almost all modern computing devices employ one or more Application Specific Integrated Circuits (ASICs), such as Central Processing Units (CPUs), Graphics Processing Units (GPUs), memory devices, Programmable Gate Arrays (PGAs) or the like. To incorporate those ASICs, devices may have a Printed Circuit Board (PCB) (referred to sometimes as just a board) on which that ASIC is mounted. Such a board (i.e., a board on which an ASIC is mounted) is often referred to as a host board. These types of host board typically also have a power supply that provides electrical power to the ASIC mounted on the board.

For certain types of ASICs requiring a relatively large amount of power (e.g., large ASICs, or ASICs with certain types of circuitry) it can be challenging to design a host board to deliver the necessary electrical power because of the large amount of current that may be required and the consequent size of power supplies required to provide such power. For example, current generation ASICs may require 1000A of current or more to power the core of the ASIC. Part and parcel with this, it may be the case that the types of ASICs that require a relatively larger amount of power may be commensurately larger in physical size (e.g., have a larger footprint). Thus, while also requiring relatively more power, such a larger ASIC may actually reduce the amount of space available on a host board (e.g., of a given size) for placing the required power supply.

What is desired, therefore, are improved systems and methods for supplying power to an ASIC, including supplying high current to an ASIC mounted on a host board.

### BRIEF DESCRIPTION OF THE DRAWINGS

The drawings accompanying and forming part of this specification are included to depict certain aspects of the disclosure. It should be noted that the features illustrated in the drawings are not necessarily drawn to scale. A more complete understanding of the disclosure and the advantages thereof may be acquired by referring to the following description, taken in conjunction with the accompanying drawings in which like reference numbers indicate like features.
FIGURES 1A and 1B are block diagrams depicting different views of one embodiment of a system for supplying power to an ASIC.
FIGURES 2A-2D are diagrams depicting examples of parts of a pin-and-collar connector.
FIGURES 3A, 3B and 4 are examples of the positioning of portions of pin-and-collar connectors according to embodiments.
FIGURE 5 is a flow diagram depicting one embodiment of a method for delivering high current to an ASIC.

### DETAILED DESCRIPTION

As discussed, ASICs in computing devices are typically mounted on a host board, where that host board includes a power supply to provide electrical power to the ASIC on the board. This type of arrangement may prove difficult because of a number of circumstances. As but one difficulty, the packaging of such an arrangement may prove problematic with certain kinds of ASICs. In particular, certain ASICs may require a relatively large amount of power (e.g., 1000A of current or more to power the core of the ASIC). In most cases, the size of a power supply required increases in association with the amount of power that the power supply is capable of supplying. Moreover, ASICs with larger power requirements are, themselves, typically larger in size. Thus, the combination of a relatively larger ASIC with a relatively larger power supply required to supply an increased amount of power coupled with the desire to limit the size of a host board may prove a significant packaging problem.

Conventional approaches to supplying power to an ASIC involve placing the power supplies on the same board as the ASIC. In some cases, the power supplies are placed on the opposite side of the host board (i.e., if the ASIC is mounted on the top side of the host board, the power supplies are mounted on the bottom of the host board). One of the problems with this approach, however, is that the mounting of the power supplies on the same board as the ASIC increases the difficulty of manufacturing the board.

Disclosed embodiments address these problems by using a host board on which the ASIC is mounted and a separate daughter board on which the power supplies (e.g., one or more power supplies) are mounted, where electrical connectors suitable for use with higher power level are used to connect the daughter board to the host board, and to carry the high current from the power supplies to the ASIC. Because conventional electrical connectors may not be capable of handling the high currents (e.g., 1000A) that are necessary for the ASIC, a pin-and-collar connector system may be used to connect the daughter board to the host board and to deliver current from the power supply on the daughter board to the ASIC on the host board. This style of connector is typically used for connecting busbars, but it is used here because it is designed for high current and can be used to connect the daughter and host boards together.

The arrangement of embodiments as disclosed herein provides a number of advantages over conventional approaches. For example, because the power supplies and ASIC are mounted on separate boards, the complexity of (e.g., each of these) boards is reduced and the manufacturing difficulty is reduced. Additionally, because the high power connectors can be disconnected and the daughter board removed from the host board, debug and repair work is facilitated. Further, mounting the power supplies on the daughter board avoids using valuable space on the host board for these components. Still further, the power can be provided from the daughter board to the host board through connectors that are positioned very near the ASIC, which reduces the difficulty of routing the power on the host board itself.

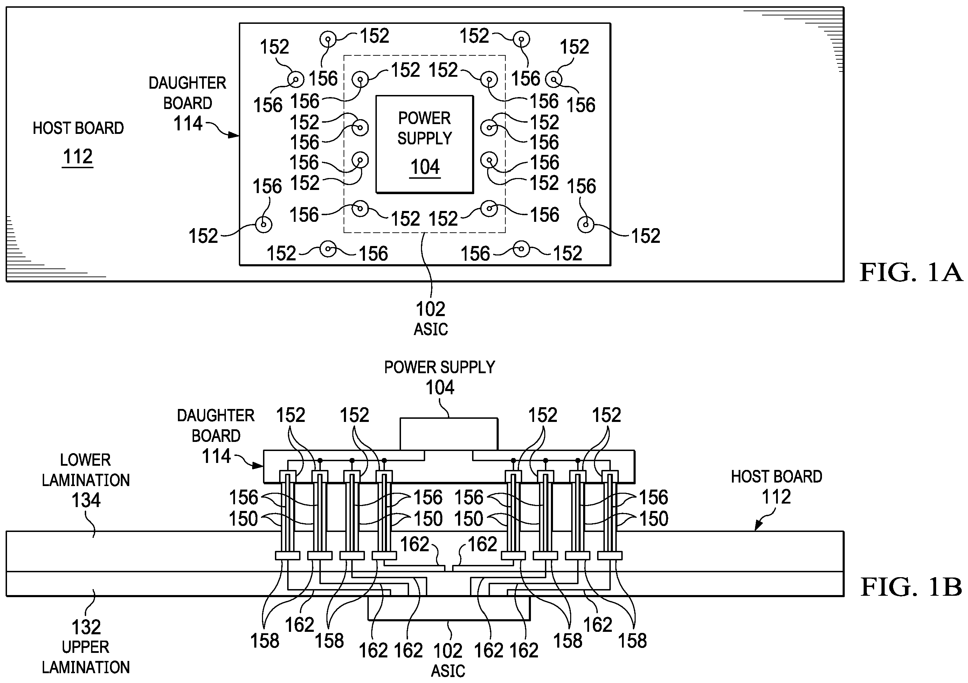

Turning now to FIGURES 1A and 1B, one embodiment of a power distribution system for ASICs is depicted. Here, the system may include a host board 112 and a daughter board 114. The host board 112 may be, for example, a laminated PCB. The daughter board 114 may also be a laminated PCB or the like. An ASIC 102 (e.g., a CPU, GPU, PGA, Field PGA (FPGA), etc.) can be mounted on one side of host board 112. A power supply 104 can be mounted on daughter board 114. The power supply 104 can, for example, be a high-power power supply capable of providing around 1000A or more of current.

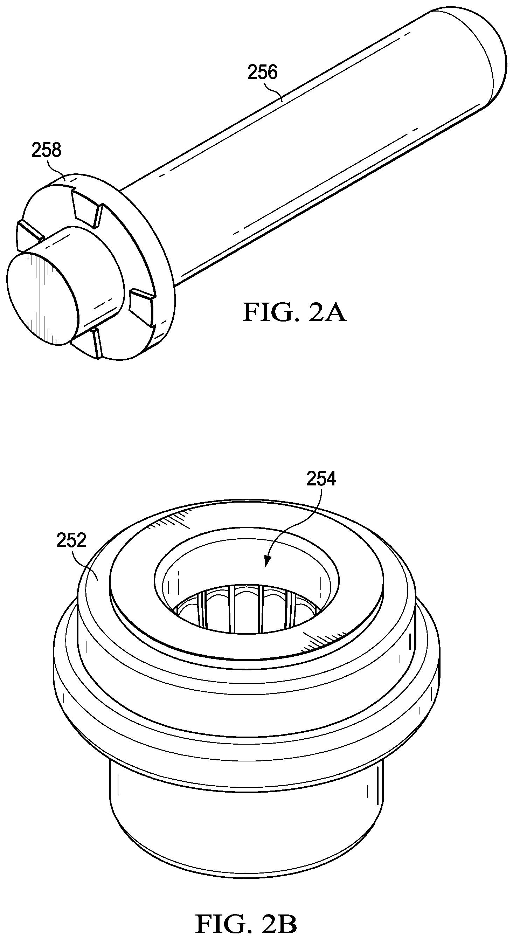

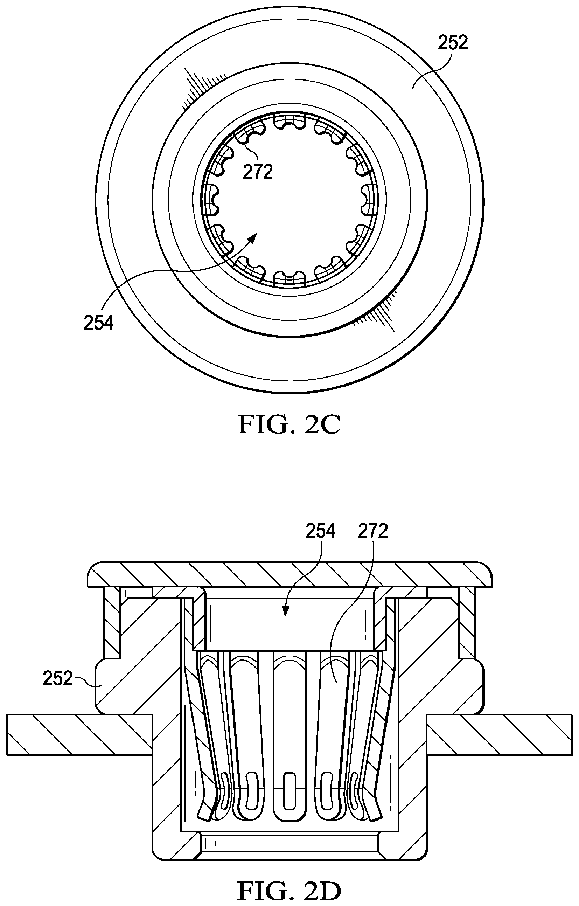

A set of power connector pins 150 connects daughter board 114 to host board 112 where the pins 150 are adapted to deliver current from the power supply 104 on the daughter board 114 to the ASIC 102 on the host board 112. These power connector pins 150 may be pin-and-collar connectors or the like. These types of pin-and-collar connectors may comprise a central post 156 with a (e.g., metallic) flange 158 connected to the post 156 adjacent to an end of the post 156. FIGURE 2A depicts one example of such a central post and flange. Specifically, in the depicted example, central post 256 is connected to flange 258 near end of post 256. Notice here that a portion of post 256 may (or may not) protrude on each side of the flange 258.

Returning to FIGURES 1A and 1B, post 156 may mate, fit into, or otherwise connect (referred to herein collectively as mating without loss of generality) with a corresponding power connector socket 152. The mating of the central post 156 of a pin-and-collar connector 150 with a corresponding power connector socket 152 may serve to electrically couple the power connector socket 152 to the post 156 and flange 158 of the power connector pin 150. In embodiments, the mating of the post 156 and the power connector socket 152 may also serve to mechanically couple the post 156 and the power connector socket 152.

FIGURES 2B-2D depict[[s]] various views of one example of such a power connector socket. In particular, FIGURE 2B depicts one view of an example power connector socket 252 with an opening 254 for accommodating a post of a power connector pin. FIGURE 2C depicts a top view of an example power connector socket. Socket 252 may include one more (e.g., deflectable) mating (e.g., contact or alignment) points 272 disposed within opening 254. Mating points 272 may include or more arms that may deflect to accommodate and contact a corresponding connector pin disposed in opening 254 and may be deflectable such that they are biased against such a connector pin disposed in the opening 254 to provide electrical (e.g., and mechanical) connection between the socket 252 and the connector pin. FIGURE 2C depicts a cross sectional view of an example power connector socket 252 including opening 254 and mating points 272.

Looking back at FIGURE 1A and 1B, then, in one embodiment, the flange 158 of the post 156 of each connector pin 150 is electrically connected to one or more electrically conductive elements 162 on the host board 112 that are electrically coupled to the ASIC 102 on the host board 112, while one or more corresponding power connector sockets 152 electrically connected to the power supply 104 are mounted on the daughter board 114. For example, power connector sockets 152 may be mounted on daughter board 114. In such embodiments, the daughter board may be a single lamination board with a mounting hole that runs through daughter board 114.

Host board 112 may be a laminated PCB comprising an upper lamination 132 and a lower lamination 134. Power planes may be placed on the lower lamination 134 and signal routing may be placed on the upper lamination 132. This arrangement may allow the post 156 to be placed on the lower lamination 134 of host board 112 without interfering with the signal routing in the upper lamination. The ASIC 102 may be mounted on a side of the host board 112 comprising, or proximate, the upper lamination 132, while a proximal end of central post 156 of each power connector pin 150 including flange 158 is mounted in or on (collectively "mounted in") lower lamination 134 of host board 112 opposite the ASIC 102.

Accordingly, in some embodiments, electrically conductive elements 162 in host board 112 electrically connecting flange 158 to ASIC 102 may comprise vias or electrical traces (e.g., on the side of the host board 112 opposite the ASIC 102). In the case of vias, these vias may extend only into lower lamination 134 or to both lower lamination 134 and upper lamination, and these vias may extend to, or through, the flange 158 of at least one of the one or more posts 156 of connector pins 150.

The mounting of a post 156 of a pin-and-collar connector 150 in the lower lamination 134 of the host board 112 may thus comprise creating a recess in the side of the host board 112 opposite the ASIC 102 (e.g., in the lower lamination 134 of the host board 112) for each post 156, and positioning the proximal end of the post 156 including flange 158 in this recess such that the flange 158 of the post 156 abuts a surface of this (second) side (e.g., lower lamination 134) of the host board 112. In such cases, lower lamination may be of thickness adapted to accommodate the recess (e.g., hole) without the recess protruding into upper lamination 132.

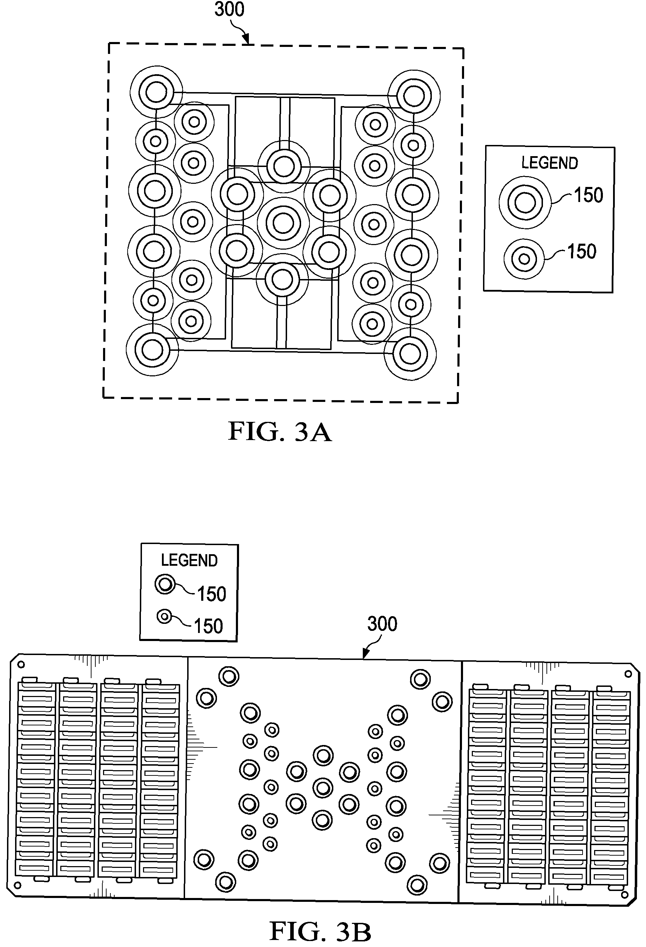

In one embodiment, the posts 156 of connector pins 150 may be placed on host board 112 directly in the via field at the back of the ASIC. This arrangement may allow direct connection of flanges 158 of posts 156 to the power vias supplying ASIC 102. Embodiments of such a placement are depicted in FIGURES 3A and 3B. In these embodiments, location of connector pins 150 is in via field 300 of an ASIC.

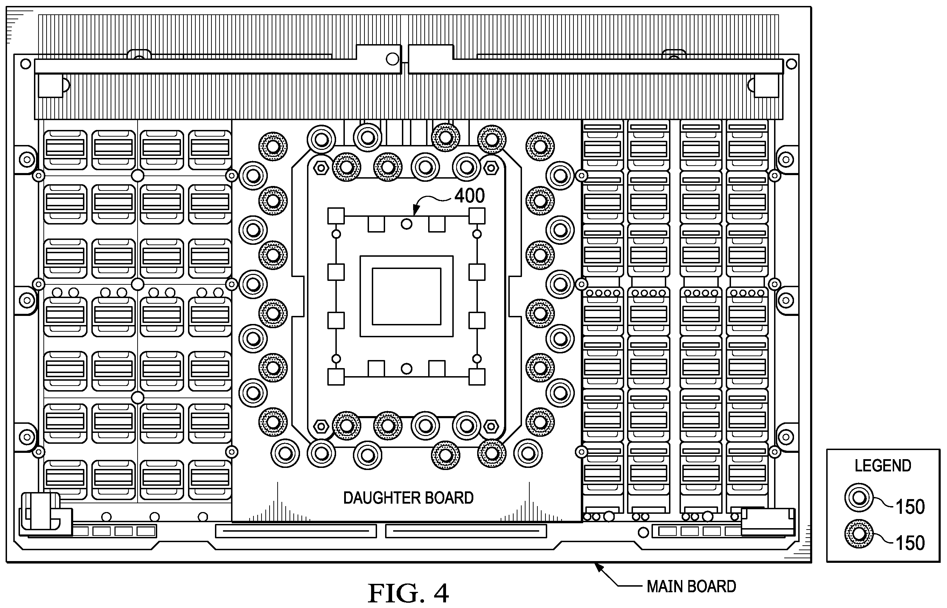

In other embodiments, the posts 156 of connector pins 150 may be placed outside the via field of ASIC 102 (e.g., to allow for decoupling capacitors to be placed directly on the power vias supplying the ASIC 102 where they may be most effective). An embodiment of such an arrangement is depicted in FIGURE 4. Here, locations of connector pins 150 may be outside via field 400.

According to embodiments, the daughter board 114 may be mounted on the host board 112 (e.g., the daughter board 114 may be electrically, mechanically, or both electrically and mechanically, connected to the host board 112 using connector pins 150) such that each of the one or more power connector sockets 152 of the daughter board 114 mates with a corresponding post 156 of the one or more poser connector pins 150 serving to electrically couple the power supply 104 on the daughter board 114 to the electrically conductive elements 162 of the host board 112 and allowing power to be delivered from the power supply 104 on the daughter board 114 through the power connector sockets 152 of the daughter board 152, and the post 156 and flange 158 of connector pins 150 to the electrically conductive elements 162 on the host board 112, and thus to the ASIC 102 on the host board 112. In particular, ASIC 102 may be mounted on one side of host board 112 and power supply 104 may be mounted on a side of daughter board 114 such that when daughter board 114 is connected to host board 112 using power connector pins 150, power supply 104 and ASIC 102 are distal from one another (e.g., allowing a closer packaging of host board 112 and daughter board 114).

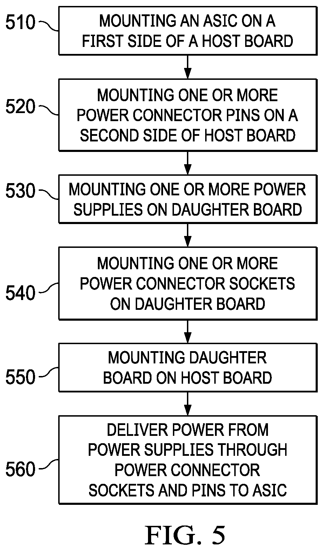

FIGURE 5 depicts a flow diagram for one embodiment of a method for delivering high current to an ASIC. Initially, an ASIC is mounted on a first side of a host board (STEP 510). The host board may comprise, for example, a laminated PCB. The laminated PCB can comprise an upper lamination on which the ASIC is mounted and a lower lamination on which the one or more connector pins are mounted. One or more power connector pins can be mounted on a second side of the host board opposite the first side (STEP 520). These power connector pins can be positioned opposite the ASIC on the host board. For example, for each of the connector pins, a recess may be created in the second side of the host board and a proximal end of the post of the connector pins may be positioned in the recess such that flange of the connector abuts a surface of the second side of the host board.

Moreover, as discussed, each of the one or more connector pins may have a cylindrical post and a metallic flange connected to the post adjacent to a proximal end of the post, where the flange is electrically connected to one or more electrically conductive elements on the host board. The electrically conductive elements can comprise, for example, vias. The electrically conductive elements may additionally or alternatively comprise one or more electrical traces on the (e.g., second side of the) host board. In one embodiment, these vias may extend only into a lower lamination of the board, or a portion of the vias may extend to both a lower and an upper lamination of the board. Additionally, in some embodiments, at least a portion of the vias may extend through the flange of at least one of the connector pins.

One or more power supplies can be mounted on a daughter board (STEP 530). Similarly, one or more power connector sockets may be mounted on the daughter board (STEP 540). The daughter board can be mounted on the host board (e.g., attached in some manner to the host board), wherein each of the one or more power connector sockets mates with a corresponding one of the one or more power connector pins when mounted (STEP 550). In this manner, power can be delivered from the one or more power supplies on the daughter board through the one or more power connector sockets and the one or more power connector pins to the ASIC on the host board (STEP 560).

It will be understood that while specific embodiments have been presented herein, these embodiments are merely illustrative, and not restrictive. Rather, the description is intended to describe illustrative embodiments, features and functions in order to provide an understanding of the embodiments without limiting the disclosure to any particularly described embodiment, feature, or function, including any such embodiment, feature, or function described. While specific embodiments of, and examples for, the embodiments are described herein for illustrative purposes only, various equivalent modifications are possible within the spirit and scope of the invention, as those skilled in the relevant art will recognize and appreciate.

As indicated, these modifications may be made in light of the foregoing description of illustrated embodiments and are to be included within the spirit and scope of the disclosure. Thus, while particular embodiments are described, a latitude of modification, various changes and substitutions are intended in the foregoing disclosures, and it will be appreciated that in some instances some features of embodiments of the invention will be employed without a corresponding use of other features, and features described with respect to one embodiment may be combined with features of other embodiments without departing from the scope and spirit of the disclosure as set forth.

Based on the above, it will be understood that the following have been disclosed:
1. A method for delivering high current to an ASIC, the method comprising:
   mounting the ASIC on a first side of a host board, the host board comprising a laminated printed circuit board (PCB);
   mounting one or more power connector pins on a second side of the host board opposite the first side,
   wherein the one or more power connector pins are positioned opposite the ASIC on the host board,
   wherein each of the one or more connector pins has a cylindrical post and a metallic flange connected to the post adjacent to a proximal end of the post, wherein the flange is electrically connected to one or more electrically conductive elements on the host board;
   mounting one or more power supplies on a daughter board;
   mounting one or more power connector sockets on the daughter board;
   mounting the daughter board on the host board, wherein each of the one or more power connector sockets mates with a corresponding one of the one or more power connector pins; and
   delivering power from the one or more power supplies on the daughter board through the one or more power connector sockets and the one or more power connector pins to the ASIC on the host board.
2. The method of clause 1, wherein the laminated PCB comprises an upper lamination on which the ASIC is mounted and a lower lamination on which the one or more connector pins are mounted.
3. The method of clause 1, wherein the electrically conductive elements comprise vias.
4. The method of clause 3, wherein at least a portion of the vias extend only into the lower lamination.
5. The method of clause 3, wherein at least a portion of the vias extend to both the lower lamination and the upper lamination.
6. The method of clause 5, wherein at least a portion of the vias extend through the flange of at least one of the one or more connector pins.
7. The method of clause 1, wherein the electrically conductive elements comprise one or more electrical traces on the second side of the host board.
8. The method of clause 1, further comprising, for each of the one or more connector pins, creating a recess in the second side of the host board and positioning a proximal end of the post in the recess, wherein the flange of the connector abuts a surface of the second side of the host board.
9. A system for providing power to an ASIC, comprising:
   a host board comprising an ASIC mounted on a first side of the host board;
   one of more power connector pins mounted on a second side of the host board, each power connector pin electrically coupled to the ASIC through one or more electrically conductive elements;
   a daughter board comprising a power supply on a first side of the daughter board;
   one or more power connector sockets mounted on the daughter board, wherein the daughter board is mounted on the host board by mating the one or more power connector pins mounted on the host board with a corresponding power connector socket mounted on the daughter board such that the power supply can supply power to the ASIC on the host board through the one or more power connector pins and power connector sockets.
10. The system of clause 9, wherein each of the one or more connector pins has a cylindrical post and a metallic flange connected to the post adjacent to a proximal end of the post, wherein the flange is electrically connected to the one or more electrically conductive elements on the host board;
11. The system of clause 10, wherein the first side of the host board and the first side of the daughter board are distal from one another when the daughter board is mounted to the host board.
12. The system of clause 11, wherein the host board is a first laminated printed circuit board (PCB).
13. The system of clause 12, wherein the daughter board is a second laminated PCB.
14. The system of clause 13, wherein the first laminated PCB comprises an upper lamination comparing the first side of the host board and a lower lamination comprising a second side of the host board.
15. The system of clause 14, wherein each flange of the one or more connector pins is mounted in the lower lamination.
16. The system of any of clauses 9 to 15, wherein the electrically conductive elements comprise vias.
17. The system of clause 16, wherein at least a portion of the vias extend only into the lower lamination or extend to both the lower lamination and the upper lamination.
18. The system of clause 16, wherein at least a portion of the vias extend through the flange of at least one of the one or more connector pins.
19. The system of any of clauses 9 to 18, wherein the electrically conductive elements comprise one or more electrical traces in the lower lamination.
20. A system for providing power to an ASIC, comprising:
   a host board comprising a first laminated printed circuit board (PCB) having an upper lamination and a lower lamination;
   an ASIC mounted on the upper lamination of the host board;
   one of more power connector pins mounted on the lower lamination, each power connector pin electrically coupled to the ASIC through one or more electrically conductive elements at least partially in the lower lamination;
   a daughter board comprising a second laminated PCB;
   a power supply on a first side of the daughter board;
   one or more power connector sockets mounted on a second side of the daughter board, wherein the daughter board is mounted on the host board by mating the one or more power connector pins mounted on the host board with a corresponding power connector socket mounted on the daughter board such that the power supply and the ASIC are distal from one another when the daughter board is mounted on the host board and the power supply can supply power to the ASIC on the host board through the one or more power connector pins and power connector sockets.

## Claims

1. A method for delivering high current to an ASIC, the method comprising:
mounting the ASIC on a first side of a host board, the host board comprising a laminated printed circuit board, PCB;
mounting one or more power connector pins on a second side of the host board opposite the first side,
wherein the one or more power connector pins are positioned opposite the ASIC on the host board,
wherein each of the one or more connector pins has a cylindrical post and a metallic flange connected to the post adjacent to a proximal end of the post, wherein the flange is electrically connected to one or more electrically conductive elements on the host board;
mounting one or more power supplies on a daughter board;
mounting one or more power connector sockets on the daughter board;
mounting the daughter board on the host board, wherein each of the one or more power connector sockets mates with a corresponding one of the one or more power connector pins; and
delivering power from the one or more power supplies on the daughter board through the one or more power connector sockets and the one or more power connector pins to the ASIC on the host board.

2. The method of claim 1, wherein the laminated PCB comprises an upper lamination on which the ASIC is mounted and a lower lamination on which the one or more connector pins are mounted.

3. The method of claim 1 or claim 2, wherein the electrically conductive elements comprise vias.

4. The method of claim 3, wherein at least a portion of the vias extend only into the lower lamination.

5. The method of claim 3, wherein at least a portion of the vias extend to both the lower lamination and the upper lamination.

6. The method of claim 5, wherein at least a portion of the vias extend through the flange of at least one of the one or more connector pins.

7. The method of any preceding claim, wherein the electrically conductive elements comprise one or more electrical traces on the second side of the host board.

8. The method of any preceding claim, further comprising, for each of the one or more connector pins, creating a recess in the second side of the host board and positioning a proximal end of the post in the recess, wherein the flange of the connector abuts a surface of the second side of the host board.

9. A system for providing power to an ASIC, comprising:
a host board;
an ASIC mounted on a first side of the host board;
one of more power connector pins mounted on a second side of the host board, each power connector pin electrically coupled to the ASIC through one or more electrically conductive elements;
a daughter board;
a power supply on a first side of the daughter board;
one or more power connector sockets mounted on the daughter board:
wherein the one or more power connector pins mounted on the host board mates with a corresponding power connector socket mounted on the daughter board to mount the daughter board on the host board and to allow the power supply to supply power to the ASIC on the host board through the one or more power connector pins and power connector sockets.

10. The system of claim 9, wherein the first side of the host board and the first side of the daughter board are distal from one another when the daughter board is mounted to the host board.

11. The system of claim 9 or claim 10, wherein the daughter board is a laminated printed circuit board, PCB.

12. The system of any of claims 9 to 11, wherein the host board is a laminated printed circuit board, PCB.

13. The system of claim 12, wherein the laminated PCB of the host board comprises an upper lamination comprising the first side of the host board and a lower lamination comprising the second side of the host board.

14. The system of any of claims 9 to 13, wherein each of the one or more connector pins has a cylindrical post and a metallic flange connected to the post adjacent to a proximal end of the post, wherein the flange is electrically connected to the one or more electrically conductive elements on the host board;

15. The system of claim 14 when dependent upon claim 13, wherein each flange of the one or more connector pins is mounted in the lower lamination.
